# EUROPEAN PATENT SPECIFICATION

(11) **EP 2 700 901 B1**
(45) Date of publication and mention of the grant of the patent: **06.03.2019**
(21) Application number: 13760762.8
(22) Date of filing: 10.01.2013
(51) Int. Cl.: G01B 11/00, G01C 3/06, G01J 1/44, G01V 8/12, H01L 27/14, G01D 5/34

(54) **LIGHT-RECEPTION-PURPOSE INTEGRATED CIRCUIT AND OPTOELECTRONIC SENSOR USING THAT INTEGRATED CIRCUIT**
INTEGRIERTE SCHALTUNG ZUM EMPFANGEN VON LICHT UND OPTOELEKTRONISCHER SENSOR MIT DIESER INTEGRIERTEN SCHALTUNG
CIRCUIT INTÉGRÉ À USAGE DE RÉCEPTION DE LUMIÈRE ET CAPTEUR OPTOÉLECTRONIQUE L'UTILISANT

(30) Priority: 15.03.2012 JP 2012059438
(43) Date of publication of application: 26.02.2014
(73) Proprietor: Omron Corporation, Kyoto-shi, Kyoto 600-8530 (JP)
(72) Inventor: TSUZUKI, Ryosuke, Kyoto-shi, Kyoto 600-8530 (JP); KAWAI, Takehiro, Kyoto-shi, Kyoto 600-8530 (JP); OKUNO, Motoharu, Kyoto-shi, Kyoto 600-8530 (JP); SHIMIZU, Tetsu, Kyoto-shi, Kyoto 600-8530 (JP)
(74) Representative: Horn Kleimann Waitzhofer Patentanwälte PartG mbB
(86) International application number: PCT/JP2013/050273
(87) International publication number: WO 2013/136826

(56) References cited:
- EP-A2- 1 209 447
- WO-A1-2011/001523
- JP-A- H01 229 567
- JP-A- 2002 252 368
- US-A- 5 757 751
- US-A- 5 757 751
- US-A- 5 814 808
- US-A1- 2005 199 786

## Description

### TECHNICAL FIELD

The present invention relates to an integrated circuit for light reception, in which a circuit processing a light receiving amount signal output from a light receiving element is incorporated, and a photoelectric sensor in which the integrated circuit is used.

### BACKGROUND ART

Photoelectric sensor can be roughly divided into transmission type sensors that receive projected light at a position facing a light projection position and reflection type sensors that project the light to an object and receive the light reflected from the object. Most photoelectric sensors determine the presence or absence of an object by the amount of received light. Reflection type sensors include distance setting type photoelectric sensors that perform detection processing to which the principle of triangulation is applied.

In a sensor (hereinafter referred to as a "light quantity detection type sensor") that performs the detection based on intensity of the light receiving amount, one system of an amplifier circuit is enough for the light receiving amount signal. On the other hand, in a distance setting type photoelectric sensor (hereinafter referred to as a "distance setting type sensor"), a bi-cell photodiode or a PSD generates a pair of light receiving amount signals in which a ratio varies depending on an image forming position of the reflected light, and the existence or non-existence of the object is detected at a reference position using an addition level and a difference level of the signals. Therefore, it is necessary to provide circuits of two systems, namely, a circuit that sums up and amplifies the light receiving amount signals and a circuit that subtracts and amplifies the light receiving amount signals.

Thus, the light quantity detection type sensor differs largely from the distance setting type sensor in a configuration of the circuit that processes the light receiving amount signal. However, there has been developed an IC chip in which the circuit suitable to both the sensors is incorporated. The IC chip will be described below.

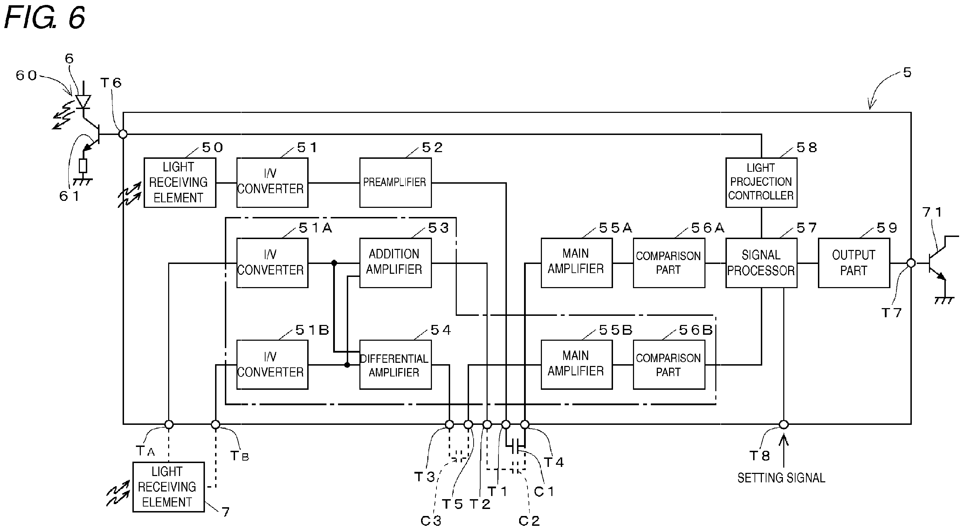

FIG. 6 illustrates a schematic configuration of the IC chip suitable to both the light quantity detection type sensor and the distance setting type sensor and a relationship with an external light projecting part 60 and an external light receiving part 70.

An IC chip 5 is a photo IC in which one light receiving element 50 (photodiode) is incorporated, and the IC chip 5 includes a function of controlling a light projection operation of the light projecting part 60.

A pair of light receiving amount signal input terminals T_{A} and T_{B} is provided in a chip body of the IC chip 5 in order to externally input the light receiving amount signal.

An I/V conversion circuit 51 and a preamplifier 52 are provided in the integrated circuit of the IC chip 5 in order to perform voltage conversion of a current signal from the internal light receiving element 50. I/V conversion circuits 51A and 51B are connected to the light receiving amount signal input terminals T_{A} and T_{B}, respectively. The signal line from each of the I/V conversion circuits 51A and 51B is branched into two routes, one of the signal lines is connected to an addition amplifier 53, and the other signal line is connected to a differential amplifier 54.

A pair of main amplifiers 55A and 55B, a pair of comparison parts 56A and 56B, a signal processor 57, a light projection controller 58, and an output part 59 are further provided in the integrated circuit of the light receiving IC chip 5. Terminals T1, T2, T3, T4, and T5 for the connection to the amplifiers 52, 53, 54, 55A, and 55B, a terminal T6 for the light projection control, an output terminal T7, and a setting signal input terminal T8 are provided in the chip body. The terminal T6 for the light projection control is connected to the light projection controller 58, the output terminal T7 is connected to the output part 59, and the setting signal input terminal T8 is connected to the signal processor 57.

The light projecting part 60 including a light emitting element 6 and a driving circuit 61 that drives the light emitting element 6 is disposed outside of the IC chip 5 while connected to the terminal T6 for the light projection control. The light projection controller 58 outputs a control signal instructing light projection timing is output under the control of the signal processor 57, and the light emitting element 6 emits the light in response to the control signal. The signal processor 57 drives the comparison parts 56A and 56B in accordance with the light projection control. The comparison parts 56A and 56B compare the voltage signals input from the main amplifiers 55A and 55B at a preceding stage to predetermined reference voltages to output signals representing magnitude relationships with respect to the reference voltages, respectively. The signal processor 57 generates a binary detection signal representing the existence or non-existence of an object based on the signals output from the comparison parts 56A and 56B. The detection signal is output to the outside through the output part 59, the output terminal T7, and an output circuit 71 connected to the terminal T7.

A setting signal representing which one of light quantity detection type processing or distance setting type processing is performed is input to the terminal T8.

In the case that the IC chip 5 is used as the light quantity detection type sensor, as indicated by a solid line in FIG. 6, the preamplifier 52 and the main amplifier 55A are connected through the terminals T1 and T4 and a coupling capacitor C1 interposed between the terminals T1 and T4. Therefore, the light receiving amount signal of the internal light receiving element 50 is input to the main amplifier 55A, and the comparison part 56A compares the level of the light receiving amount signal to the reference voltage.

On the other hand, because the terminals T2 and T3, which are related to the addition amplifier 53 and the differential amplifier 54, become an open state, the signals from the amplifiers 53 and 54 become invalid.

In response to the setting signal, the signal processor 57 drives only the comparison part 56A to generate the detection signal representing the existence or non-existence of the object.

In the distance setting type sensor, as indicated by a dotted line in FIG. 6, a light receiving element 7 (such as a bi-cell photodiode and a PSD) having two output systems is connected as the external light receiving part 70 to the light receiving amount signal input terminals T_{A} and T_{B}, the addition amplifier 53 and the main amplifier 55A are connected through the terminals T2 and T4 and a coupling capacitor C2 interposed between the terminals T2 and T4, and the differential amplifier 54 and the main amplifier 55B are connected through the terminals T3 and T5 and a coupling capacitor C3 interposed between the terminals T3 and T5. On the other hand, the terminal T1 corresponding to the preamplifier 52 is in the open state.

According to the above connections, a signal representing the summing up and amplifying the pair of light receiving amount signals from the light receiving part 70 is input to the main amplifier 55A, and a signal representing the differentially amplifying the pair of light receiving amount signals is input to the main amplifier 55B. The comparison parts 56A and 57B compare the signals amplified by the main amplifiers 55A and 55B to the reference voltages, respectively. Then the signals representing the comparison results are input to the signal processor 57.

Based on the setting signal from the terminal T8, the signal processor 57 processes the signals from the comparison parts 56A and 56B to generate the detection signal.

Patent Document 1 discloses a specific configuration of the light receiving IC chip. Patent Document 1 also discloses the configuration in which the light receiving element having one output system is externally provided in addition to the bi-cell light receiving element or the PSD (See paragraphs 0075 to 0077, FIG. 10 in Patent Document 1).

### PRIOR ART DOCUMENTS

### PATENT DOCUMENT

Patent Document 1: Japanese Unexamined Patent Publication No. 2002-252368.

The document EP1209447 A2 discloses an integrated circuit according to the state of the art.

### SUMMARY OF THE INVENTION

### PROBLEMS TO BE SOLVED BY THE INVENTION

Advantageously, the integrated circuit of the light receiving IC chip 5 in FIG. 6 can be used in both the light quantity detection type photoelectric sensor and the distance setting type photoelectric sensor. At the same time, because the IC chip 5 includes many circuits (portion surrounded by an alternate long and short dash line in FIG. 6) dedicated to the external light receiving element, an economic efficiency is degraded in the case that the IC chip 5 is introduced into the light quantity detection type sensor. Additionally, because the IC chip 5 includes many circuits, the IC chip 5 is hard to be downsized.

Nowadays the applications of the photoelectric sensor are spread in various fields. Particularly, the demand of the light quantity detection type sensor is much higher than that of the distance setting type sensor, and there is a need of users for downsizing and cost reduction of the sensor. However, the circuit configuration of the IC chip 5 does not satisfy the need of users. When the integrated circuit for light reception for the light quantity detection type sensor and the integrated circuit for light reception for the distance setting type sensor are separately produced, the production efficiency is degraded, and the cost is hard to be sufficiently reduced.

The present invention has been devised to solve the problems described above, and a first object thereof is to implement the downsizing and the cost reduction of the integrated circuit for light reception, which can be used in both the light quantity detection type photoelectric sensor and the distance setting type photoelectric sensor.

A second object of the present invention is to be able to provide the excellent-function photoelectric sensor at a reasonable price using the integrated circuit for light reception.

### MEANS FOR SOLVING THE PROBLEMS

In order to achieve the first object, the present invention provides an integrated circuit for light reception including: an amplifier circuit that includes a function of amplifying a single light receiving amount signal, a function of summing up and amplifying a pair of light receiving amount signals, and a function of differentially amplifying a pair of light receiving amount signals; a switching processor that receives the light receiving amount signal or signals to be amplified by one of the three functions of the amplifier circuit, and relays the light receiving amount signal or signals to the amplifier circuit; a setting signal input part for externally inputting a setting signal in order to enable one of the three functions of the amplifier circuit; a signal processor that controls an operation of the switching processor in accordance with the setting signal input from the setting signal input part such that the switching processor relays the light receiving amount signal which is the target amplified by the function enabled by the setting signal, the signal processor processing a signal output from the amplifier circuit based on an operation definition determined by the enabled function; an output part that outputs a signal representing a processing result of the signal processor; and a pair of light receiving amount signal input parts that takes in the light receiving amount signal generated by an external light receiving element and introduces the light receiving amount signal into the switching processor.

In the case that the integrated circuit for light reception having the above configuration is incorporated in the light quantity detection type sensor, for example, the light receiving element for the light quantity detection type sensor is connected to one of the pair of light receiving amount signal input parts, and the setting signal enabling the function of amplifying the single light receiving amount signal is input to the setting signal input part. Therefore, after the light receiving amount signal generated by the light receiving element is relayed to the amplifier circuit and amplified by the switching processor, the processing is performed to the post amplification signal.

On the other hand, in the case that the distance setting type sensor is produced, the two integrated circuits for light reception are introduced, and the light receiving part including the light receiving element that performs the outputs of the two systems is connected to the light receiving amount signal input part of each of the integrated circuits for light reception. The setting signal enabling the function of summing up and amplifying the pair of light receiving amount signals is input to the setting signal input part of one of the integrated circuits for light reception, and the setting signal enabling the function of differentially amplifying the pair of light receiving amount signals is input to the setting signal input part of the other integrated circuit for light reception.

The use of the combination of the two integrated circuits for light reception can perform the addition calculation processing and the difference calculation processing of the light receiving amount signals to perform the distance setting type signal processing.

Like the configuration in FIG. 6 and the configuration disclosed in Patent Document 1, the light receiving element for the light receiving amount detection type sensor can be incorporated in the integrated circuit for light reception. In this case, the signal from the internal light receiving element is introduced into the amplifier circuit in response to the input of the setting signal enabling the function of amplifying the single light receiving amount signal.

In a first preferred embodiment, in the integrated circuit for light reception, a signal line from one of the pair of light receiving amount signal input parts is branched into two routes. The switching processor includes a first switch that is connected to a signal line from the other light receiving amount signal input part, in which a signal line is not branched, and second and third switches that are connected to the signal lines from the light receiving amount signal input part in which the signal line is branched. The amplifier circuit includes a differential amplifier in which an addition signal of signals through the first and second switches is used as one of inputs while a signal through the third switch is used as the other input.

The signal processor closes the first switch while opening the second and third switches in response to the input of the setting signal enabling the function of amplifying the single light receiving amount signal, the signal processor closes the first and second switches while opening the third switch in response to the input of the setting signal enabling the function of summing up and amplifying the pair of light receiving amount signals, and the signal processor closes the first and third switches while opening the second switch in response to the input of the setting signal enabling the function of differentially amplifying the pair of light receiving amount signals.

In the case that the light quantity detection type sensor is produced by the integrated circuit for light reception of the first preferred embodiment, one integrated circuit for light reception is incorporated, and the light receiving part having the one output system is connected to the light receiving amount signal input part in which the signal line is not branched. Only the signal from the light receiving amount signal input part to which the light receiving part is connected is introduced into the differential amplifier by inputting the setting signal enabling the function of amplifying the single light receiving amount signal.

In the case that the distance setting type sensor is produced, the pair of integrated circuits for light reception is incorporated, and the output lines from the light receiving part having the two output system are connected to the light receiving amount signal input parts of the integrated circuit for light reception. The addition signal of each of the light receiving amount signals is introduced into the differential amplifier by inputting the setting signal enabling the function of summing up and amplifying the pair of light receiving amount signals to one of the integrated circuits for light reception, and the light receiving amount signals are introduced as the individual input signal into the differential amplifier by inputting the setting signal enabling the function of differentially amplifying the pair of light receiving amount signals to the other integrated circuit for light reception.

In a second preferred embodiment, the integrated circuit for light reception further includes a light receiving part that includes a light receiving element having one output system.

The signal line from one of the pair of light receiving amount signal input parts is branched into two routes. The switching processor includes a first switch that is connected to the internal light receiving part, a second switch that is connected to the signal line from the other light receiving amount signal input part in which the signal line is not branched, and third and fourth switches that are connected to the signal lines from the light receiving amount signal input part in which the signal line is branched. The amplifier circuit includes a differential amplifier in which an addition signal of signals through the first, second, and third switches is used as one of inputs while a signal through the fourth switch is used as the other input.

The signal processor closes the first switch while opening the second, third, and fourth switches in response to the input of the setting signal enabling the function of amplifying the single light receiving amount signal, the signal processor closes the second and third switches while opening the first and fourth switches in response to the input of the setting signal enabling the function of summing up and amplifying the pair of light receiving amount signals, and the signal processor closes the second and fourth switches while opening the first and third switches in response to the input of the setting signal enabling the function of differentially amplifying the pair of light receiving amount signals.

In the case that the light quantity detection type sensor is produced by the integrated circuit for light reception of the second preferred embodiment, one integrated circuit for light reception is incorporated, and only the light receiving amount signal from the light receiving part of the integrated circuit for light reception is introduced into the differential amplifier by inputting the setting signal enabling the function of amplifying the single light receiving amount signal.

In the case that the distance setting type sensor is produced, the pair of integrated circuits for light reception is incorporated, and the output lines from the light receiving part having the two output systems are connected to the light receiving amount signal input parts of the integrated circuit for light reception. The addition signal of each of the light receiving amount signals is introduced into the differential amplifier by inputting the setting signal enabling the function of summing up and amplifying the pair of light receiving amount signals to one of the integrated circuit for light reception, and the light receiving amount signals are introduced as the individual input signal into the differential amplifier by inputting the setting signal enabling the function of differentially amplifying the pair of light receiving amount signals to the other IC chip.

According to the first and second preferred embodiments, the common circuit can perform all the pieces of amplification processing using the three ways of input of setting signals, so that the number of circuit elements included in the integrated circuit for light reception can largely be decreased. In the case that the integrated circuit for light reception of the second preferred embodiment is introduced into the light quantity detection type sensor, convenience is enhanced because the internal light receiving element can be used.

In a third preferred embodiment, the integrated circuit for light reception further includes a communication part that conducts communication with another integrated circuit for light reception of the same kind. The signal processor processes the signal output from the amplifier circuit while transmitting and receiving a signal for synchronizing operation timing to and from another integrated circuit for light reception through the communication part in response to the input of one of the setting signal enabling the function of summing up and amplifying the pair of light receiving amount signals and the setting signal enabling the function of differentially amplifying the pair of light receiving amount signals.

According to the third preferred embodiment, in the pair of integrated circuits for light reception incorporated in the distance setting type sensor, the integrated circuits for light reception perform the signal processing at the synchronized timing, so that the processing to the addition signal of the light receiving amount signals and the processing to the difference signal of the light receiving amount signals can be performed at the synchronized timing to ensure the detection accuracy.

In the third preferred embodiment, one of the setting signal enabling the function of summing up and amplifying the pair of light receiving amount signals and the setting signal enabling the function of differentially amplifying of the pair of light receiving amount signals may cause the signal processor of the integrated circuit for light reception, which receives the setting signal, to act as a master, and the other setting signal may cause the signal processor of the integrated circuit for light reception, which receives the setting signal, to act as a slave. In this case, the signal processor of the master outputs a control signal representing timing, in which the output from the amplifier circuit is taken in and processed, to the signal processor of the slave through the communication part, and takes in and processes the output from the amplifier circuit of own circuit in response to the output. The signal processor of the slave takes in and processes the output from the amplifier circuit of the own circuit in response to the reception of the control signal from the signal processor of the master through the communication part.

According to the above configuration, the signal processor of one of the pair of integrated circuits for light reception becomes the master to operate the other integrated circuit for light reception at the timing synchronized with the operation of the own circuit, so that the timing of the processing to the addition signal of the light receiving amount signals can easily be synchronized with the timing of the processing to the difference signal of the light receiving amount signals.

Additionally, in the third preferred embodiment, the signal processing results of the integrated circuits for light reception can be integrated by the signal processor of one of the IC chips to generate the output detection signal.

A light quantity detection type sensor according to the present invention includes: a light projecting part that projects light; and a light receiving part that receives the light of the light projecting part or light reflected from a detection target with respect to the light from the light projecting part and outputs a single light receiving amount signal. Herein the light receiving part is incorporated in the integrated circuit for light reception while connected to the switching processor. The setting signal enabling the function of amplifying the single light receiving amount signal is input to the setting signal input part of the integrated circuit for light reception.

As described above, the setting signal enabling the function of amplifying the single light receiving amount signal is input to the setting signal input part of the integrated circuit for light reception in which the light receiving part is incorporated, which allows the integrated circuit for light reception to act as the light receiving signal processing circuit for the light quantity detection type sensor. Therefore, the light quantity detection type sensor can easily be produced.

In the case that the sensor is produced as the reflection type photoelectric sensor, the light projecting part and the integrated circuit for light reception are assembled in the same casing. In the case that the sensor is produced as the transmission type photoelectric sensor, the light projecting part and the integrated circuit for light reception are separately assembled in the different casings.

A distance setting type sensor according to the present invention includes: a light projecting part that projects light; a light receiving part including a light receiving element that receives the light reflected from a detection target with respect to the light from the light projecting part and outputs a pair of light receiving amount signals; and a pair of integrated circuits for light reception that is connected to the light receiving part. Each of the integrated circuits for light reception has the above configuration. The setting signal enabling the function of summing up and amplifying the pair of light receiving amount signals is input to the setting signal input part of one of the pair of integrated circuits for light reception while the setting signal enabling the function of differentially amplifying the pair of light receiving amount signals is input to the setting signal input part of the other integrated circuit for light reception.

As described above, the light receiving amount signal input parts of the pair of integrated circuits for light reception are connected to the light receiving element that outputs the pair of light receiving amount signals, one of the integrated circuits for light reception adds and amplifies the light receiving amount signals and performs the post-amplification signal processing, and the other integrated circuit for light reception differentiates and amplifies the light receiving amount signals and performs the post-amplification signal processing, which allows the distance detection type sensor to be easily produced.

### EFFECTS OF THE INVENTION

According to the present invention, the integrated circuit for light reception in which the number of unnecessary circuits is largely decreased is produced in the light quantity detection type sensor, so that the downsizing and cost reduction of the integrated circuit for light reception can be implemented. Particularly, because the large-scale production of the light receiving amount integrated circuit suitable to the light quantity detection type sensor in demand can be performed, the cost is largely reduced, and the compact light quantity detection type sensor can be provided at a reasonable price.

It is necessary to introduce the two light receiving amount integrated circuits into the distance setting type sensor. However, because the individual circuit is reduced, the enlargement of the sensor can be prevented. The cost is reduced by the large-scale production of the light receiving amount integrated circuit having the unified standard, so that the distance setting type sensor can be provided at a reasonable price.

### BRIEF DESCRIPTION OF THE DRAWINGS

FIG. 1 is a block diagram illustrating a configuration example of a light receiving IC chip to which the present invention is applied;
FIG. 2 is a block diagram illustrating an example in which the light receiving IC chip in FIG. 1 is applied to a light quantity detection type sensor;
FIG. 3 is a block diagram illustrating an example in which the light receiving IC chip in FIG. 1 is applied to a distance setting type sensor;
FIG. 4(1) is a timing chart illustrating a main operation between IC chips of the distance setting type sensor, and FIG. 4(2) is a view illustrating a signal flow in the timing chart;
FIG. 5 is a view illustrating a configuration of a switching processor of a light receiving IC chip having a different configuration.
FIG. 6 is a block diagram illustrating a conventional example of a light receiving IC chip that can be applied to both the light quantity detection type photoelectric sensor and a distance setting type photoelectric sensor.

### MODE FOR CARRYING OUT THE INVENTION

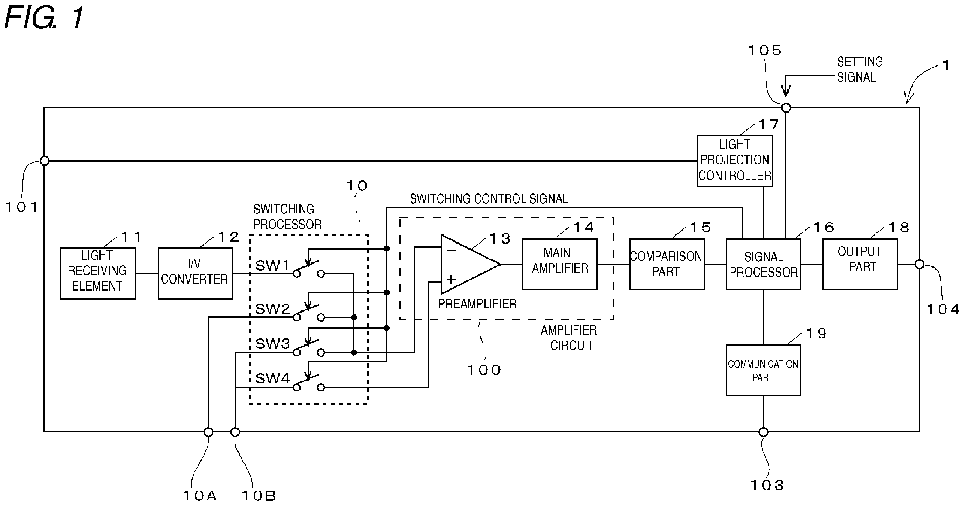

FIG. 1 illustrates a configuration example of an IC chip 1 having incorporated therein an integrated circuit for light reception to which the present invention is applied.

The IC chip 1 of this embodiment is a photo IC including a light receiving element 11 and an I/V conversion circuit 12. The IC chip 1 also includes a switching processor 10, an amplifier circuit 100, a comparison part 15, a signal processor 16, a light projection controller 17, an output part 18, and a communication part 19. The amplifier circuit 100 includes a preamplifier 13 and a main amplifier 14. The comparison part 15 is a comparator, the light projection controller 17 is an analog circuit, and each of the signal processor 16 and the communication part 19 is constructed by a logic circuit. The output part 18 includes a buffer circuit.

Terminals, such as a pair of light receiving amount signal input terminals 10A and 10B, a light projection control terminal 101, a communication line connecting terminal 103, a detection signal output terminal 104, and a setting signal input terminal 105, are provided in a chip body. The terminal 101 is connected to the light projection controller 17, the terminal 103 is connected to the communication part 19, the terminal 104 is connected to the output part 18, and the terminal 105 is connected to the signal processor 16.

A signal amplified by each of the amplifiers 13 and 14 of the amplifier circuit 100 is input to the comparison part 15 and compared to a predetermined reference voltage, and a signal representing a comparison result is generated.

Sometimes a coupling capacitor is provided between the amplifiers 13 and 14 as needed basis. In such cases, a pair of terminals is provided in the chip body, the coupling capacitor is connected between the terminals, and the amplifiers 13 and 14 may be connected through the terminals and the coupling capacitor like the conventional example in FIG. 6.

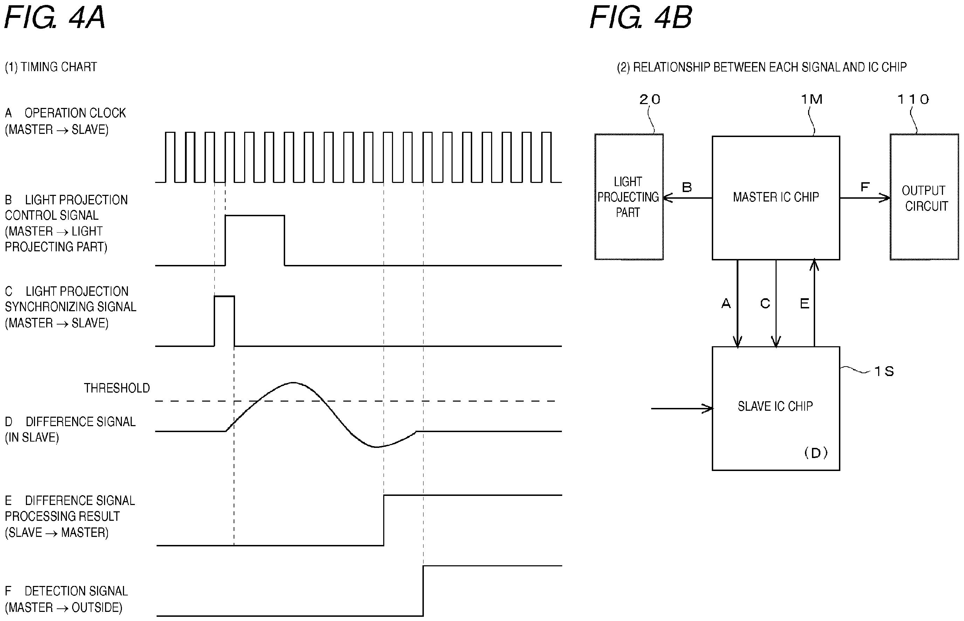

The signal processor 16 transmits a light projection control signal ((B) in FIG. 4) described later to the terminal 101 through the light projection controller 17, and the signal processor 16 drives the comparison part 15 to take in the signal representing the comparison result, and performs processing to the signal to generate a detection signal representing a processing result. The detection signal is output to an outside of the IC chip 1 through the output part 18.

The light receiving element 11 of the IC chip 1 is a photodiode having only one system of a route to which a current signal generated by the photoelectric conversion is output. The output current signal (basic light receiving amount signal) is converted into a voltage signal (a light receiving amount signal of a processing target) by the I/V converter 12, and introduced to the switching processor 10.

The IC chip 1 of this embodiment is configured to be able to process the pair of light receiving amount signals input from the light receiving amount signal input terminals 10A and 10B in addition to the light receiving amount signal of the light receiving element 11. The light receiving amount signals of the processing target are switched by the switching processor 10.

Signal lines from the light receiving amount signal input terminals 10A and 10B are led to the switching processor 10, and the signal line from the terminal 10B is branched into two on the way.

The switching processor 10 includes four switches SW1, SW2, SW3, and SW4, the switch SW1 is connected to the I/V converter 12, and the switch SW2 is connected to the signal line from the light receiving amount signal input terminal 10A. One of the signal lines branched from the light receiving amount signal input terminal 10B is connected to the switch SW3, and the other signal line is connected to the switch SW4.

The preamplifier 13 is a differential amplifier. The signal lines at the subsequent stages of the switches SW1, SW2, and SW3 are coupled and connected to a negative-side terminal of the preamplifier 13. The signal line at the subsequent stage of the switch SW4 is connected to a positive-side terminal of the preamplifier 13. A property of the signal output from the preamplifier 13 changes in accordance with switching states of the switches SW1 to SW4.

Opening and closing operations of the switches SW1, SW2, SW3, and SW4 are controlled by a switching control signal from the signal processor 16. In FIG. 1, for the sake of convenience, the routes of the switching control signal to the switches SW1 to SW4 are expressed by one line. However, actually the signal (a high level or a low level) controlling the opening and closing of the switch is individually provided to each of the switches SW1 to SW4.

There are three patterns for a content of the switching control signal provided to each of the switches SW1 to SW4. Which pattern is used in the control is set by a setting signal provided to the signal processor 16 from the terminal 105.

The three control patterns will be described below.

In the first control pattern, only the switch SW1 is closed, and the switches SW2, SW3, and SW4 are opened (hereinafter referred to as "Pattern 1"). In the second control pattern, the switches SW2 and SW3 are closed, and the switches SW1 and SW4 are opened (hereinafter referred to as "Pattern 2"). In the third control pattern, the switches SW2 and SW4 are closed, and the switches SW1 and switch SW3 are opened (hereinafter referred to as "Pattern 3").

As described above, the content of the signal relayed to the preamplifier 13 is varied in each pattern by switching the opening and closing states of the switches SW1 to SW4 of the switching processor 10 using the switching control signal from the signal processor 16. As a result, the property of the signal output from the preamplifier 13 changes in each pattern.

The setting signal of this embodiment is three kinds of voltage signals including 0 V, and the setting signal is always applied to the signal processor 16 by connecting the terminal 105 to a power-supply line (not illustrated). For example, the terminal 105 is connected to a line of 0 V in the case that Pattern 1 is set, the terminal 105 is connected to a line of a predetermined voltage v1 in the case that Pattern 2 is set, and the terminal 105 is connected to a line of a predetermined voltage v2 higher than the voltage v1 in the case that Pattern 3 is set. However, the configuration of the setting signal is not limited to that described above. For example, when the IC chip 1 is powered on, the setting signal constructed by a digital signal having a configuration of several bits is input, and the setting corresponding to the input may be maintained until shutoff of the power. Two input terminals may be provided for the setting signals, either 0 V or a predetermined voltage is applied to each terminal, and the three patterns may be expressed by combinations of the voltages.

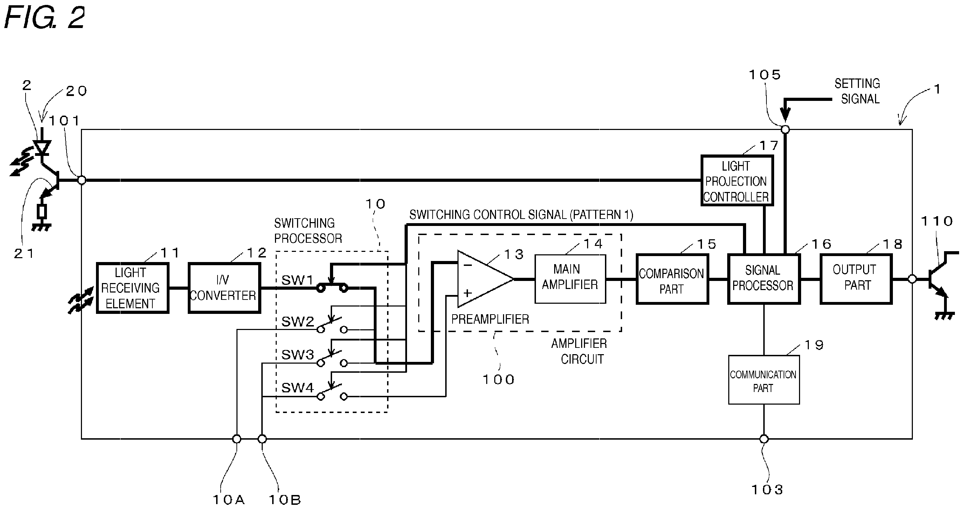

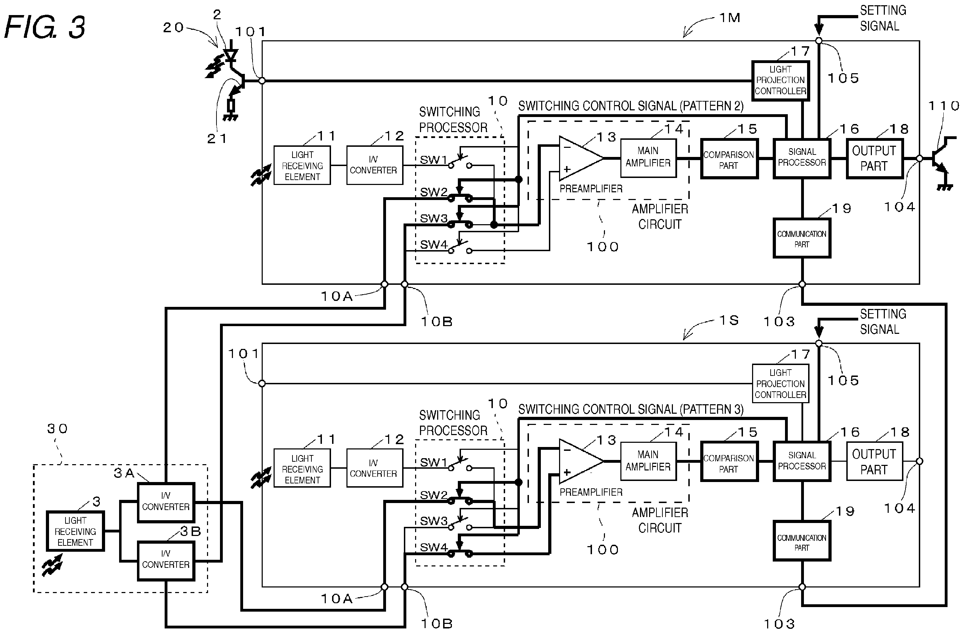

A specific example of the photoelectric sensor in which the IC chip 1 is incorporated will be described below with reference to FIGS. 2 and 3. A block and a signal line of the configuration used in the IC chip 1 are indicated by a bold line in FIGS. 2 and 3.

FIG. 2 illustrates a configuration example of a light quantity detection type sensor in which the IC chip 1 is used.

A light projecting part 20 is incorporated in the light quantity detection type sensor, and the IC chip 1 is introduced as a light receiving part into the light quantity detection type sensor. The light projecting part 20 includes a light emitting element 2, such as an LED, and a driving circuit 21 that drives the light emitting element 2. The driving circuit 21 of the light projecting part 20 is connected to the light projection control terminal 101.

An output circuit 110 is connected to the output terminal 104. On the other hand, the light receiving amount signal input terminals 10A and 10B and the communication terminal 103 are set to an open state.

The setting signal instructing the control of Pattern 1 is input from the terminal 105, and the switching control signal having the content corresponding to the setting is provided from the signal processor 17 to the switches SW1 to SW4. Because the switch SW1 is closed while the switches SW2, SW3, and SW4 are opened, only the signal through the switch SW1 is transmitted to the subsequent stage.

According to the switching processor 10 and the preamplifier 13 in FIG. 1, when the voltage input to the positive-side terminal of the preamplifier 13 becomes an internal reference voltage by opening the switch SW4, the preamplifier 13 acts as a circuit that adds and amplifies the signals from the switches SW1, SW2, and SW3. However, in the example in FIG. 2, only the signal through the switch SW1, namely, the light receiving amount signal of the internal light receiving element 11 is amplified because the switches SW2 and SW3 are also opened in addition to the switch SW4.

After the light receiving amount signal output from the preamplifier 13 is further amplified by the main amplifier 14, the light receiving amount signal is input to the comparison part 15, and compared to the reference voltage. Therefore, a signal representing a magnitude relationship between the light receiving amount of the internal light receiving element 11 and a reference level is input to the signal processor 16.

FIG. 3 illustrates an example in which the IC chip 1 is used in a distance setting type sensor.

The two IC chips 1 are incorporated in the distance setting type sensor. In FIG. 3, one of the IC chips is designated by a numeral 1M and the other IC chip is designated by a numeral 1S.

In addition to the IC chips 1M and 1S and the light projecting part 20, an external light receiving part 30 is incorporated in the photoelectric sensor. The light receiving part 30 is a board on which a light receiving element 3 (such as a bi-cell photodiode and a PSD) and a pair of I/V conversion circuits 3A and 3B are mounted. The light receiving element 3 has a function of outputting the pair of light receiving amount signals in which a light quantity ratio varies according to an incident position of reflected light. The pair of I/V conversion circuits 3A and 3B processes each light receiving amount signal. The I/V conversion circuit 3A is connected to the light receiving amount signal input terminal 10A of each of the IC chips 1M and 1S, and the I/V conversion circuit 3B is connected to the light receiving amount signal input terminal 10B of each of the IC chips 1M and 1S.

The communication terminals 103 and 103 of the IC chips 1M and 1S are connected to each other through the communication line.

In the IC chip 1M, the driving circuit 21 of the light projecting part 20 is connected to the light projection control terminal 101, the output circuit 110 is connected to the output terminal 104, and the terminals 101 and 104 of the IC chip 1S are set to the open state.

The setting signal instructing the control of Pattern 2 is input to the terminal 105 of the IC chip 1M. The signal processor 16 of the IC chip 1M outputs the switching control signal for Pattern 2 in response to the setting signal. Therefore, in the switching processor 10 of the IC chip 1M, the switches SW2 and SW3 are closed and the switches SW1 and SW4 are opened. According to the opening and closing state, the preamplifier 13 adds and amplifies the signal through the switch SW2 and the signal through the switch SW3.

In the pair of light receiving amount signals of the external light receiving element 3, the light receiving amount signal input from the terminal 10A is passed through the switch SW2, and the light receiving amount signal input from the other terminal 10B is passed through the switch SW3. Therefore, a signal (hereinafter referred to as an "addition signal") representing an addition level of the light receiving amount signals is output from the preamplifier 13 by the switch control. The addition signal is amplified by the main amplifier 14, input to the comparison part 15, and compared to the reference voltage. Therefore, the signal representing the magnitude relationship between the addition level of the pair of light receiving amount signals from the external light receiving part 30 and the reference level is input to the signal processor 16.

The setting signal instructing the control of Pattern 3 is input to the terminal 105 of the IC chip 1S. The signal processor 16 of the IC chip 1S outputs the switching control signal for Pattern 3 in response to the setting signal. Therefore, in the switching processor 10 of the IC chip 1S, the switches SW2 and SW4 are closed and the switches SW1 and SW3 are opened. Only the signal from the switch SW2 is input to the negative-side terminal of the preamplifier 13, and the signal from the switch SW4 is input to the positive-side terminal, thereby differentially amplifying the two kinds of the signals.

In the pair of light receiving amount signals of the external light receiving element 3, the light receiving amount signal input from the terminal 10A is passed through the switch SW2, and the light receiving amount signal input from the other terminal 10B is passed through the switch SW4. Therefore, a signal (hereinafter referred to as a "difference signal") representing a difference level of the light receiving amount signals is output from the preamplifier 13 by the switch control. The difference signal is amplified by the main amplifier 14, input to the comparison part 15, and compared to the reference voltage. Therefore, the signal representing the magnitude relationship between the difference level of the pair of light receiving amount signals from the external light receiving part 30 and the reference level is input to the signal processor 16.

The setting signal input to the terminal 105 not only expresses the opening and closing pattern of the switches SW1 to SW4 of the switching processor 10 but also has a function of defining the operation of the signal processor 16. Specifically, in the case that the setting signal of Pattern 1 is provided as illustrated in the example in FIG. 2, the operation of the light quantity detection type sensor is defined in the signal processor 16 and the signal processing is performed only to the signal from the comparison part 15 at the preceding stage.

On the other hand, in the case that the setting signal of Pattern 2 or Pattern 3 is provided as illustrated in the example in FIG. 3, the signal processor 16 is defined so as to be operated while transmitting and receiving the signal to and from the signal processor 16 of another IC chip 1 through the communication part 19. Specifically, the signal processor 16 to which the setting signal of Pattern 2 is provided becomes a master while the signal processor 16 to which the setting signal of Pattern 3 is provided becomes a slave, and the signal processor 16 of the slave performs the processing at the initiative of the signal processor 16 of the master, and transmits the processing result to the master. In the example in FIG. 3, the signal processor 16 of the upper-stage IC chip 1M becomes the master, and the signal processor 16 of the lower-stage IC chip 1M becomes the slave.

Hereinafter, for the sake of convenience, the IC chip 1M including the signal processor 16 operated as the master is referred to as a "master IC chip 1M", and the IC chip 1S including the signal processor 16 operated as the slave is referred to as a "slave IC chip 1S". The signal transmission and reception between the master IC chips 1M and 1S and the operations of the master IC chips 1M and 1S are described in a part of the IC chip 1.

FIG. 4(1) is a timing chart illustrating a relationship among main signals in the inside and the outside of each IC chip 1, and FIG. 4(2) is a schematic diagram illustrating a relationship between each signal of the timing chart and the IC chip 1.

The master IC chip 1M outputs a light projection control signal (B) to the light projecting part 20 while generating an operation clock (A) at a constant cycle. The master IC chip 1M also outputs the operation clock (A) and a light projection synchronizing signal (C) to the slave IC chip 1S. The slave IC chip 1S outputs a signal (E) representing the processing result of the difference signal not to the output part 18 of the own circuit but to master IC chip 1M through the communication part 19.

As illustrated in FIG. 4(1), in this embodiment, an on period of the light projection control signal (B) is set to a length of three cycles of the operation clock (A), and the light projection control signal (B) rises at a time synchronized with rise of the operation clock (A) at a predetermined time point. The light projection synchronizing signal (C) rises in synchronization with fall of the operation clock immediately before the rise of the light projection control signal (B), and the on state of the light projection synchronizing signal (C) is maintained until the operation clock used as the reference of the rise of the light projection control signal (B) falls.

Detection light is projected from the light projecting part 20 by the light projection control signal (B), and the light reflected from an object is incident to the light receiving element 3. Therefore, the signals input to the light receiving amount signal input terminals 10A and 10B of the IC chips 1M and 1S also change, and the addition signal and the difference signal, which are output from the preamplifier 13, change in accordance with the above changes of the signals..

In FIG. 4(1), a difference signal (D) generated through the amplification processing of the slave IC chip 1S is illustrated together with the reference level (a dotted line) compared by the comparison part 15 (the comparator).

In the slave IC chip 1S, the comparison part 15 is operated in response to the light projection synchronizing signal (C) from the master IC chip 1M. When the comparison part 15 detects a signal larger than the reference value to put the slave IC chip 1S into the on state, the signal (E) representing the processing result rises after a given time elapses since the light projection synchronizing signal (C) is received.

In the master IC chip 1M, at the time corresponding to the transmission of the light projection synchronizing signal to the slave IC chip 1S, the comparison part 15 is driven to acquire the signal representing the magnitude relationship between the addition level of the light receiving amount signal and the reference level. A level of a detection signal (F) is decided and output through processing (for example, an AND calculation) of integrating the signal acquired by the own circuit and the signal (E) received from the slave IC chip 1S.

Although the IC chip 1 of this embodiment includes all the circuits necessary for the use in the light quantity detection type sensor, the amplifier and the comparison part, which are dedicated to the distance setting type, are not incorporated in the IC chip 1. Accordingly, compared with the conventional example in FIG. 6, the circuit can considerably be reduced to downsize the IC chip 1.

The IC chip 1 has the configuration suitable to the light quantity detection type sensor in high demand, large-scale production can be performed to considerably reduce the cost. Therefore, the compact, high-performance light quantity detection type sensor can be provided at a reasonable price.

The distance setting type sensor can be produced when the two IC chips 1 are used. In the distance setting type sensor, one of the IC chips 1 generates the addition signal of the pair of light receiving amount signals from the light receiving part 30 while the other IC chip 1 generates the difference signal of the light receiving amount signals, and the processing to the addition signal and the processing to the difference signal are synchronously performed, so that accuracy of the detection signal can be ensured.

Although the two IC chips 1 are required, a size of each IC chip 1 is reduced. Therefore, the enlargement of the distance setting type sensor can be prevented. As described above, the large-scale production of the IC chip 1 can be performed to reduce the cost. Therefore, the distance setting type sensor can also be provided at a reasonable price.

In the examples in FIGS. 3 and 4, the IC chip 1M performing the addition calculation processing of the light receiving amount signals is set to the master, and the IC chip 1S performing the difference calculation processing of the light receiving amount signals is set to the slave. Alternatively, the relationship between the master and the slave may be reversed.

Alternatively, the main function may be shared by both the IC chips 1 while the IC chips 1 are not discriminated from each other as the master and the slave. For example, the IC chip 1M performing the addition calculation processing performs the light projection control and the synchronization control between the operations of the IC chips 1M and 1S, and the IC chip 1S performing the difference calculation processing may integrate the processing results from the IC chip 1M and the own circuit to output the detection signal.

In the foregoing description, the switching operation of the switching processor 10 and the operation definition of the signal processor 16 are changed by the setting signal representing the three ways of the control pattern. Additionally, the reference voltage of the comparison part 15 may be switched in each pattern by the switching processing performed by the signal processor 16.

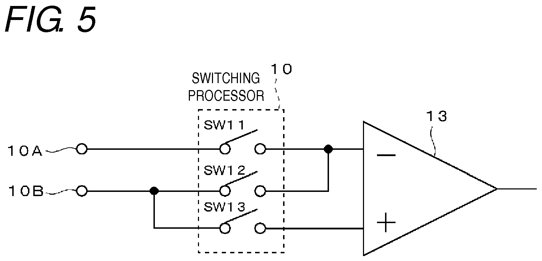

The light receiving part (the light receiving element 11 and the I/V converter 12) for the light quantity detection type sensor is incorporated in the IC chip 1 of the foregoing embodiment. Alternatively, the light receiving part is not incorporated in the IC chip, but the light receiving part may externally be provided. In such cases, as illustrated in FIG. 5, the switches SW11, SW12, and SW13 may be provided in the switching processor 10.

In the example in FIG. 5, the signal line from the light receiving amount signal input terminal 10A is connected to the switch SW11. One of the signal lines from the light receiving amount signal input terminal 10B is connected to the switch SW12, and the other signal line is connected to the switch SW13. The signal lines at the subsequent stages of the switches SW11 and SW12 are coupled and connected to the negative-side terminal of the preamplifier 13. The signal line at the subsequent stage of the switch SW13 is connected to the positive-side terminal of the preamplifier 13.

Because other circuits in the IC chip of this embodiment are identical to those in FIG. 1, the illustration and description are omitted.

In the case that the IC chip of this embodiment in FIG. 5 is used in the light quantity detection type sensor, the light receiving part having one output system is connected to the light receiving amount signal input terminal 10A, the switch SW11 is closed, and the switches SW12 and SW13 are opened. Therefore, the preamplifier 13 simply amplifies the light receiving amount signal from the light receiving part.

On the other hand, the two IC chips 1 are introduced into the distance setting type sensor, and the light receiving part 30 that outputs the pair of light receiving amount signals is connected to the light receiving amount signal input terminals 10A and 10B of each IC chip 1. In one of the IC chips 1, the switches SW11 and SW12 are closed, and the switch SW13 is opened, whereby the preamplifier 13 acts as the circuit that adds and amplifies the light receiving amount signals input from the terminals 10A and 10B. In the other IC chip 1, the switches SW12 and SW13 are closed, and the switch SW11 is opened, whereby the preamplifier 13 differentiates and amplifies the light receiving amount signals input from the terminals 10A and 10B.

Even if the IC chip of the example in FIG. 5 is used, like the foregoing embodiment, the setting signal instructing any one of the three control patterns is input to the signal processor 16, and the operation definition of the signal processor 16 and the opening and closing patterns of the switches SW11, SW12, and SW13 are set in accordance with the setting signal. In the pair of IC chips incorporated in the distance setting type sensor, one of IC chips performs the addition amplification processing while the other IC chip performs the differential amplification processing, and one of the IC chips becomes the master to synchronize the timing of the signal processing performed to the post-amplification signal. Therefore, the processing to the difference signal and the processing to the addition signal can be synchronized with each other to generate the high-accuracy detection signal.

Alternatively, in the IC chip, it is conceivable that the circuit configuration of the switching processor 10 changes as follows. Two kinds of preamplifiers, namely, an addition amplifier and a differential amplifier are disposed at the subsequent stage of the switching processor 10, the addition amplifier amplifies the signal from the light receiving part having one output system and performs the addition amplification of the pair of light receiving amount signals, and the differential amplifier differentiates and amplifies the pair of light receiving amount signals. Alternatively, three preamplifiers are disposed, one of the preamplifiers amplifies the signal from the light receiving part having one output system, one of the remaining two preamplifiers adds and amplifies the pair of light receiving amount signals, and the other amplifier differentiates and amplifies the pair of light receiving amount signals.

According to these configurations, although the circuit becomes slightly larger, only one main amplifier and only one comparison part are sufficient. Therefore, compared with the conventional example, the IC chip can sufficiently be downsized.

The application range of the above integrated circuits having the various configurations is not limited to the IC chip. For example, a board on which the similar integrated circuit is mounted may be used while assembled in the casing of the sensor.

### DESCRIPTION OF SYMBOLS

- 1 (1M, 1S): Light receiving IC chip
- 2: Light emitting element
- 3: External light receiving element
- 10: Switching processor
- 11: Light receiving element of IC chip
- 13: Preamplifier
- 16: Signal processor
- 19: Communication part
- 20: Light projecting part
- 30: Light receiving part
- 10A, 10B: Light receiving amount signal input terminal
- 100: Amplifier circuit
- 105: Setting signal input terminal

## Claims

1. An integrated circuit (1 ,1M, 1S) for light reception that processes a light receiving amount signal generated by a light receiving element (11), the integrated circuit (1 ,1M, 1S) for light reception comprising:
an amplifier circuit (100) that includes a function of amplifying a single light receiving amount signal, a function of summing up and amplifying a pair of light receiving amount signals, and a function of differentially amplifying a pair of light receiving amount signals;
a switching processor (10) that receives the light receiving amount signal or signals to be amplified by one of the three functions of the amplifier circuit (100), and relays the light receiving amount signal or signals to the amplifier circuit (100);
a setting signal input part (105) for externally inputting a setting signal in order to enable one of the three functions of the amplifier circuit (100);
a signal processor (16) that controls an operation of the switching processor (10) in accordance with the setting signal input from the setting signal input part (105) such that the switching processor (10) relays the light receiving amount signal or signals, which is or are to be amplified by the function enabled by the setting signal, the signal processor (16) processing a signal output from the amplifier circuit (100) based on an operation definition determined by the enabled function;
an output part that outputs a signal representing a processing result of the signal processor (16); and
a pair of light receiving amount signal input parts (10A, 10B) that takes in the light receiving amount signal generated by an external light receiving element and introduces the light receiving amount signal into the switching processor (10).

2. The integrated circuit for light reception according to claim 1, wherein
a signal line from one of the pair of light receiving amount signal input parts (10A, 10B) is branched into two routes,
the switching processor (10) includes a first switch (SW1) that is connected to a signal line from the other light receiving amount signal input part in which a signal line is not branched, and second and third switches (SW2, SW3) that are connected to the signal lines from the light receiving amount signal input part in which the signal line is branched,
the amplifier circuit (100) includes a differential amplifier in which an adding signal of signals through the first and second switches (SW1, SW2) is used as one of inputs while a signal through the third switch (SW3) is used as the other input,
the signal processor (16) closes the first switch (SW1) while opening the second and third switches (SW2, SW3) in response to the input of the setting signal enabling the function of amplifying the single light receiving amount signal, the signal processor (16) closes the first and second switches (SW1, SW2) while opening the third switch (SW3) in response to the input of the setting signal enabling the function of summing up and amplifying the pair of light receiving amount signals, and the signal processor (16) closes the first and third switches (SW1, SW3) while opening the second switch (SW2) in response to the input of the setting signal enabling the function of differentially amplifying the pair of light receiving amount signals.

3. The integrated circuit for light reception according to claim 1, further comprising
a light receiving part (30) that includes a light receiving element having one output system, wherein
the signal line from one of the pair of light receiving amount signal input parts (10A, 10B) is branched into two routes,
the switching processor (10) includes a first switch (SW1) that is connected to the light receiving part (30), a second switch (SW12 that is connected to the signal line from the other light receiving amount signal input part in which the signal line is not branched, and third and fourth switches (SW3. SW4) that are connected to the signal lines from the light receiving amount signal input part in which the signal line is branched,
the amplifier circuit (100) includes a differential amplifier in which an addition signal of signals through the first, second, and third switches (SW1, SW2, SW3) is used as one of inputs while a signal through the fourth switch (SW4) is used as the other input,
the signal processor (16) closes the first switch (SW1) while opening the second, third, and fourth switches (SW2, SW3, SW4) in response to the input of the setting signal enabling the function of amplifying the single light receiving amount signal, the signal processor (16) closes the second and third switches (SW2, SW3) while opening the first and fourth switches (SW1, SW4) in response to the input of the setting signal enabling the function of summing up and amplifying the pair of light receiving amount signals, and the signal processor (16) closes the second and fourth switches (SW2, SW4) while opening the first and third switches (SW1, SW3) in response to the input of the setting signal enabling the function of differentially amplifying the pair of light receiving amount signals.

4. The integrated circuit for light reception according to any one of claims 1 to 3, further comprising
a communication part (19) that conducts communication with another integrated circuit (1, 1M, 1S) for light reception of the same kind, wherein
the signal processor (16) processes the signal output from the amplifier circuit (100) while transmitting and receiving a signal synchronizing operation timing to and from another integrated circuit (1 ,1M, 1S) for light reception through the communication part (19) in response to the input of one of the setting signal enabling the function of summing up and amplifying the pair of light receiving amount signals and the setting signal enabling the function of differentially amplifying the pair of light receiving amount signals.

5. The integrated circuit for light reception according to claims 1 to 3,
further comprising
a communication part (19) that conducts communication with another integrated circuit (1 ,1M, 1S) for light reception of the same kind, wherein
one of the setting signal enabling the function of summing up and amplifying the pair of light receiving amount signals and the setting signal enabling the function of differentially amplifying of the pair of light receiving amount signals causes the signal processor (16) of the integrated circuit (1 ,1M, 1S) for light reception, which receives the setting signal, to act as a master, and the other setting signal causes the signal processor (16) of the integrated circuit (1 ,1M, 1S) for light reception, which receives the setting signal, to act as a slave, and
the signal processor (16) of the master outputs a control signal representing timing, in which the output from the amplifier circuit (100) is taken and processed, to the signal processor (16) of the slave through the communication part (19), and takes in and processes the output from the amplifier circuit (100) of the own circuit in response to the output, and the signal processor (16) of the slave takes in and processes the output from the amplifier circuit (100) of the own circuit in response to the reception of the control signal from the signal processor (16) of the master through the communication part (19).

6. A photoelectric sensor comprising:
a light projecting part (20) that projects light; and
an integrated circuit (1 ,1M, 1S) for light reception according to claim 1 including a light receiving part (30) that receives the light from the light projecting part (20) or light reflected from a detection target with respect to the light from the light projecting part (20) and outputs a single light receiving amount signal, wherein
the light receiving part (30) is incorporated in the integrated circuit (1 ,1M, 1S) for light reception while connected to the switching processor (10), and
the setting signal enabling the function of amplifying the single light receiving amount signal is input to the setting signal input part (105) of the integrated circuit (1 ,1M, 1S) for light reception.

7. A photoelectric sensor comprising:
a light projecting part (20) that projects light;
a light receiving part (30) including a light receiving element that receives the light reflected from a detection target with respect to the light of the light projecting part (20) and outputs a pair of light receiving amount signals; and
a pair of integrated circuits (1 ,1M, 1S) for light reception according to claim 1 that is connected to the light receiving part (30), wherein
the setting signal enabling the function of summing up and amplifying the pair of light receiving amount signals is input to the setting signal input part (105) of one of the pair of integrated circuits (1M, 1S) for light reception while the setting signal enabling the function of differentially amplifying the pair of light receiving amount signals is input to the setting signal input part (105) of the other integrated circuit (1M, 1S) for light reception.

8. The photoelectric sensor according to claim 7, wherein
each one of the pair of integrated circuits (1M, 1S) for light reception further includes a communication part (19) that conducts communication with the other integrated circuit (1M, 1S) for light reception, and
the signal processor (16) processes the signal output from the amplifier circuit (100) while transmitting and receiving a signal for synchronizing operation timing of the pair of integrated circuits (1M, 1S) for light reception from and to the other integrated circuit (1M, 1S) for light reception through the communication part (19).

9. The photoelectric sensor according to claim 8, wherein
one of the setting signal enabling the function of summing up and amplifying the pair of light receiving amount signals and the setting signal enabling the function of differentially amplifying the pair of light receiving amount signals causes the signal processor (16) of the integrated circuit (1 ,1M, 1S) for light reception, which receives the setting signal, to act as a master, and the other setting signal causes the signal processor (16) of the integrated circuit (1 ,1M, 1S) for light reception, which receives the setting signal, to act as a slave, and
the signal processor (16) of the master outputs a control signal representing timing, in which the output from the amplifier circuit (100) is taken and processed, to the signal processor (16) of the slave through the communication part (19), and takes in and processes the output from the amplifier circuit (100) of the own circuit in response to the output, and the signal processor (16) of the slave takes in and processes the output from the amplifier circuit (100) of the own circuit in response to the reception of the control signal from the signal processor (16) of the master through the communication part (19).

## Patentansprüche

1. Integrierter Schaltkreis (1, 1M, 1S) zum Empfangen von Licht, der ein durch ein Lichtempfangselement (11) erzeugtes Lichtempfangsmengensignal verarbeitet, wobei der integrierte Schaltkreis (1, 1M, 1S) zum Empfangen von Licht aufweist:
einen Verstärkerschaltkreis (100), der eine Funktion eines Verstärkens eines einzelnen Lichtempfangsmengensignals, eine Funktion eines Aufsummierens und Verstärkens eines Paars von Lichtempfangsmengensignalen und eine Funktion eines differentiellen Verstärkens eines Paars von Lichtempfangsmengensignalen umfasst;
einen Umschaltprozessor (10), der das Lichtempfangsmengensignal oder die Lichtempfangsmengensignale, das oder die durch eine der drei Funktionen des Verstärkerschaltkreises (100) zu verstärken sind, empfängt und das Lichtempfangsmengensignal oder die Lichtempfangsmengensignale an den Verstärkerschaltkreis (100) weitergibt;
einen Einstellsignal-Eingabeabschnitt (105) zum externen Eingeben eines Einstellsignals, um eine der drei Funktionen des Verstärkerschaltkreises (100) zu aktivieren;
einen Signalprozessor (16), der einen Betrieb des Umschaltprozessors (10) in Übereinstimmung mit der Einstellsignaleingabe von dem Einstellsignal-Eingabeabschnitt (105) derart steuert, dass der Umschaltprozessor (10) das Lichtempfangsmengensignal oder die Lichtempfangsmengensignale weitergibt, welches oder welche durch die durch das Einstellsignal aktivierte Funktion zu verstärken ist oder sind, wobei der Signalprozessor (16) eine Signalausgabe aus dem Verstärkerschaltkreis (100) anhand einer durch die aktivierte Funktion bestimmte Betriebsdefinition verarbeitet;
einen Ausgabeabschnitt, der ein Signal ausgibt, das ein Verarbeitungsergebnis des Signalprozessors (16) repräsentiert; und
ein Paar von Lichtempfangsmengensignal-Eingabeabschnitten (10A, 10B), welches das durch ein externes Lichtempfangselement erzeugte Lichtempfangsmengensignal aufnimmt und das Lichtempfangsmengensignal dem Umschaltprozessor (10) zuführt.

2. Integrierter Schaltkreis zum Empfangen von Licht gemäß Anspruch 1, wobei
eine Signalleitung von einem des Paars von Lichtempfangsmengensignal-Eingabeabschnitten (10A, 10B) in zwei Zweige verzweigt ist,
der Umschaltprozessor (10) einen ersten Schalter (SW1), der mit einer Signalleitung des anderen Lichtempfangsmengensignal-Eingabeabschnitt verbunden ist, bei welchem die Signalleitung nicht verzweigt ist, und einen zweiten und dritten Schalter (SW2, SW3) umfasst, die mit den Signalleitungen aus dem Lichtempfangsmengensignal-Eingabeabschnitt verbunden sind, bei welchem die Signalleitung verzweigt ist,
der Verstärkerschaltkreis (100) einen differentiellen Verstärker umfasst, in welchem ein Addiersignal der Signale über den ersten und zweiten Schalter (SW1, SW2) als einer der Eingaben verwendet wird, während ein Signal über den dritten Schalter (SW3) als andere Eingabe verwendet wird,
wobei der Signalprozessor (16) in Antwort auf die Eingabe eines Einstellsignals, das die Funktion des Verstärkens des einzelnen Lichtempfangsmengensignals aktiviert, den ersten Schalter (SW1) schließt, während er den zweiten und dritten Schalter (SW2, SW3) öffnet, wobei der Signalprozessor (16) in Antwort auf die Eingabe eines Einstellsignals, das die Funktion des Aufsummierens und Verstärkens des Paars von Lichtempfangsmengensignalen aktiviert, den ersten und zweiten Schalter (SW1, SW2) schließt, während er den dritten Schalter (SW3) öffnet, und wobei der Signalprozessor (16) in Antwort auf die Eingabe eines Einstellsignals, das die Funktion eines differentiellen Verstärkens des Paars von Lichtempfangsmengensignalen aktiviert, den ersten und dritten Schalter (SW1, SW3) schließt, während er den zweiten Schalter (SW2) öffnet.

3. Integrierter Schaltkreis zum Empfangen von Licht gemäß Anspruch 1, welcher ferner aufweist:
einen Lichtempfangsabschnitt (30), der ein Lichtempfangselement umfasst, welches ein Ausgabesystem aufweist, wobei
die Signalleitung von einem des Paars von Lichtempfangsmengensignal-Eingabeabschnitten (10A, 10B) in zwei Zweige verzweigt ist,
der Umschaltprozessor (10) einen ersten Schalter (SW1), der mit dem Lichtempfangsabschnitt (30) verbunden ist, einen zweiten Schalter (SW2), der mit der Signalleitung des anderen Lichtempfangsmengensignal-Eingabeabschnitt verbunden ist, bei welchem die Signalleitung nicht verzweigt ist, und einen dritten und vierten Schalter (SW3, SW4) umfasst, die mit den Signalleitungen aus dem Lichtempfangsmengensignal-Eingabeabschnitt verbunden sind, bei welchem die Signalleitung verzweigt ist,
der Verstärkerschaltkreis (100) einen differentiellen Verstärker umfasst, in welchem ein Additionssignal von Signalen über die ersten, zweiten und dritten Schalter (SW1, SW2, SW3) als einer der Eingaben verwendet wird, während ein Signal über den vierten Schalter (SW4) als andere Eingabe verwendet wird,
wobei der Signalprozessor (16) in Antwort auf die Eingabe eines Einstellsignals, das die Funktion des Verstärkens des einzelnen Lichtempfangsmengensignals aktiviert, den ersten Schalter (SW1) schließt, während er den zweiten, dritten und vierten Schalter (SW2, SW3, SW4) öffnet, wobei der Signalprozessor (16) in Antwort auf die Eingabe eines Einstellsignals, das die Funktionen des Aufsummierens und Verstärkens des Paars von Lichtempfangsmengensignalen aktiviert, den zweiten und dritten Schalter (SW2, SW3) schließt, während er den ersten und vierten Schalter (SW1, SW4) öffnet, und wobei der Signalprozessor (16) in Antwort auf die Eingabe des Einstellsignals, das die Funktion eines differenziellen Verstärkens des Paars von Lichtempfangsmengensignalen aktiviert, den zweiten und vierten Schalter (SW2, SW4) schließt, während er den ersten und dritten Schalter (SW1, SW3) öffnet.

4. Integrierter Schaltkreis zum Empfangen von Licht gemäß einem der Ansprüche 1 bis 3, welcher ferner aufweist:
einen Kommunikationsabschnitt (19), der eine Kommunikation mit einem anderen integrierten Schaltkreis (1, 1M, 1S) zum Empfangen von Licht derselben Art durchführt, wobei
der Signalprozessor (16) in Antwort auf die Eingabe eines von dem Einstellsignal, das die Funktion des Aufsummierens und Verstärkens des Paars von Lichtempfangsmengensignalen aktiviert, und dem Einstellsignal, das die Funktion des differenziellen Verstärkens des Paars von Lichtempfangsmengensignalen aktiviert, die Signalausgabe aus dem Verstärkerschaltkreis (100) verarbeitet, während er über den Kommunikationsabschnitt (19) eine Signalsynchronisierungs-Vorgangssteuerung zu und von dem anderen integrierten Schaltkreis (1, 1M, 1S) zum Empfangen von Licht sendet und empfängt.

5. Integrierter Schaltkreis zum Empfangen von Licht gemäß einem der Ansprüche 1 bis 3, welcher ferner aufweist:
einen Kommunikationsabschnitt (19), der die Kommunikation mit einem anderen integrierten Schaltkreis (1, 1M, 1S) zum Empfangen von Licht derselben Art durchführt, wobei
eines von dem Einstellsignal, das die Funktion des Aufsummierens und Verstärkens des Paars von Lichtempfangsmengensignalen aktiviert, und dem Einstellsignal, das die Funktion des differenziellen Verstärkens des Paars von Lichtempfangsmengensignalen aktiviert, den das Einstellsignal empfangende Signalprozessor (16) des integrierten Schaltkreises (1, 1M, 1S) zum Empfangen von Licht veranlasst, als ein Master zu fungieren, und das andere Einstellsignal den das Einstellsignal empfangende Signalprozessor (16) des integrierten Schaltkreises (1, 1M, 1S) zum Empfangen von Licht veranlasst, als ein Slave zu fungieren, und
der Signalprozessor (16) des Masters ein Steuersignal ausgibt, das eine Zeitsteuerung repräsentiert, wobei die Ausgabe des Verstärkerschaltkreises (100) über den Kommunikationsabschnitt (19) an den Signalprozessor (16) des Slaves gegeben und verarbeitet wird, und die Ausgabe aus dem Verstärkerschaltkreis (100) des eigenen Schaltkreises in Antwort auf die Ausgabe genommen und verarbeitet wird, und der Signalprozessor (16) des Slaves die Ausgabe aus dem Verstärkerschaltkreis (100) des eigenen Schaltkreises in Antwort auf den Empfang des Steuersignals aus dem Signalprozessor (16) des Masters über den Kommunikationsabschnitt (19) nimmt und verarbeitet.

6. Photoelektrischer Sensor, welcher aufweist:
einen Lichtprojektionsabschnitt (20), der Licht projiziert; und
einen integrierten Schaltkreis (1, 1M, 1S) zum Empfangen von Licht gemäß Anspruch 1, der einen Lichtempfangsabschnitt (30) umfasst, der Licht aus dem Lichtprojektionsabschnitt (20) oder Licht empfängt, das von einem Detektionsziel bezogen auf das Licht aus dem Lichtprojektionsabschnitt (20) reflektiert wird, und ein einzelnes Lichtempfangsmengensignal ausgibt, wobei
der Lichtempfangsabschnitt (30) in dem integrierten Schaltkreis (1, 1M, 1S) zum Empfangen von Licht enthalten ist, während er mit dem Umschaltprozessor (10) verbunden ist, und
das Einstellsignal, das die Funktion des Verstärkens des einzelnen Lichtempfangsmengensignals aktiviert, in den Einstellsignal-Eingabeabschnitt (105) des integrierten Schaltkreises (1, 1M, 1S) zum Empfangen von Licht eingegeben wird.

7. Photoelektrischer Sensor, welcher aufweist:
einen Lichtprojektionsabschnitt (20), der Licht projiziert;
einen Lichtempfangsabschnitt (30), der ein Lichtempfangselement umfasst, das Licht, das von einem Detektionsziel bezogen auf das Licht aus dem Lichtprojektionsabschnitt (20) reflektiert wird, und ein Paar von Lichtempfangsmengensignalen ausgibt; und
ein Paar von integrierten Schaltkreisen (1, 1M, 1S) zum Empfangen von Licht gemäß Anspruch 1, das mit dem Lichtempfangsabschnitt (30) verbunden ist, wobei
das Einstellsignal, das die Funktion des Aufsummierens und Verstärkens des Paars von Lichtempfangsmengensignalen aktiviert, an den Einstellsignal-Eingabeabschnitt (105) von einem des Paars von integrierten Schaltkreisen (1M, 1S) zum Empfangen von Licht eingegeben wird, während das Einstellsignal, das die Funktion eines differentiellen Verstärkens des Paars von Lichtempfangsmengensignalen aktiviert, an den Einstellsignal-Eingabeabschnitt (105) des anderen integrierten Schaltkreises (1M, 1S) zum Empfangen von Licht eingegeben wird.

8. Photoelektrischer Sensor gemäß Anspruch 7, wobei
jeder des Paars von integrierten Schaltkreisen (1, 1M, 1S) zum Empfangen von Licht ferner einen Kommunikationsabschnitt (19) umfasst, der Kommunikation mit dem anderen integrierten Schaltkreis (1M, 1S) zum Empfangen von Licht durchführt, und
der Signalprozessor (16) das aus dem Verstärkerschaltkreis (100) ausgegebene Signal verarbeitet, während er ein Signal zum Synchronisieren einer Betriebssteuerung des Paars von integrierten Schaltkreisen (1M, 1S) zum Empfangen von Licht von und zu dem anderen integrierten Schaltkreis (1M, 1S) zum Empfangen von Licht über den Kommunikationsabschnitt (19) sendet und empfängt.

9. Photoelektrischer Sensor gemäß Anspruch 8, wobei
eines von dem Einstellsignal, das die Funktion des Aufsummierens und Verstärkens des Paars von Lichtempfangsmengensignalen aktiviert, und dem Einstellsignal, das die Funktion des differentiellen Verstärkens des Paars von Lichtempfangsmengensignalen aktiviert, den Signalprozessor (16) des integrierten Schaltkreises (1, 1M, 1S) zum Empfangen von Licht, welcher das Einstellsignal empfängt, veranlasst, als ein Master zu fungieren, und das andere Einstellsignal den Signalprozessor (16) des integrierten Schaltkreises (1,1M, 1S) zum Empfangen von Licht, welcher das Einstellsignal empfängt, veranlasst, als ein Slave zu fungieren, und
der Signalprozessor (16) des Masters ein Steuersignal ausgibt, das eine Zeitsteuerung repräsentiert, wobei die Ausgabe aus dem Verstärkerschaltkreis (100) an den Signalprozessor (16) des Slaves über den Kommunikationsabschnitt (19) gegeben und verarbeitet wird, und die Ausgabe des Verstärkerschaltkreises (100) des eigenen Schaltkreises in Antwort auf die Ausgabe genommen und verarbeitet wird, und der Signalprozessor (16) des Slaves die Ausgabe aus dem Verstärkerschaltkreis (100) des eigenen Schaltkreises in Antwort auf den Empfang des Steuersignals von dem Signalprozessor (16) des Masters über den Kommunikationsabschnitt (19) nimmt und verarbeitet.

## Revendications

1. Circuit intégré (1, 1M, 1S) de réception de lumière qui traite un signal de quantité de réception de lumière généré par un élément de réception de lumière (11), le circuit intégré (1, 1M, 1S) de réception de lumière comprenant :
un circuit amplificateur (100) qui comprend une fonction d'amplification d'un unique signal de quantité de réception de lumière, une fonction de calcul de somme et d'amplification de deux signaux de quantité de réception de lumière, et une fonction d'amplification différentielle de deux signaux de quantité de réception de lumière ;
un processeur de commutation (10) qui reçoit le signal ou les signaux de quantité de réception de lumière devant faire l'objet d'une amplification par l'une des trois fonctions du circuit amplificateur (100), et qui relaie le signal ou les signaux de quantité de réception de lumière vers le circuit amplificateur (100) ;
une partie d'entrée (105) de signal de consigne permettant une entrée externe d'un signal de consigne afin d'activer l'une des trois fonctions du circuit amplificateur (100) ;
un processeur de signal (16) qui commande une opération du processeur de commutation (10) conformément au signal de consigne entré à partir de la partie d'entrée (105) de signal de consigne de sorte que le processeur de commutation (10) relaie le signal ou les signaux de quantité de réception de lumière, qui doit ou doivent faire l'objet d'une amplification par la fonction activée par le signal de consigne, le processeur de signal (16) traitant un signal délivré par le circuit amplificateur (100) sur la base d'une définition d'opération déterminée par la fonction activée ;
une partie de sortie qui délivre un signal représentant un résultat de traitement du processeur de signal (16) ; et
deux parties d'entrée (10A, 10B) de signal de quantité de réception de lumière qui prélèvent le signal de quantité de réception de lumière généré par un élément de réception de lumière externe et qui introduisent le signal de quantité de réception de lumière dans le processeur de commutation (10).

2. Circuit intégré de réception de lumière selon la revendication 1, dans lequel
une ligne de signal provenant de l'une des deux parties d'entrée (10A, 10B) de signal de quantité de réception de lumière fait l'objet d'une ramification en deux trajets,
le processeur de commutation (10) comprend un premier commutateur (SW1) qui est connecté à une ligne de signal de l'autre partie d'entrée de signal de quantité de réception de lumière dans laquelle une ligne de signal n'a pas fait l'objet d'une ramification, et des deuxième et troisième commutateurs (SW2, SW3) qui sont connectés aux lignes de signal de la partie d'entrée de signal de quantité de réception de lumière dans laquelle la ligne de signal a fait l'objet d'une ramification,
le circuit amplificateur (100) comprend un amplificateur différentiel dans lequel un signal d'addition de signaux passant par les premier et deuxième commutateurs (SW1, SW2) sert de première entrée parmi les entrées tandis qu'un signal passant par le troisième commutateur (SW3) sert d'autre entrée,
le processeur de signal (16) ferme le premier commutateur (SW1) tout en ouvrant les deuxième et troisième commutateurs (SW2, SW3) en réponse à l'entrée du signal de consigne activant la fonction d'amplification de l'unique signal de quantité de réception de lumière, le processeur de signal (16) ferme les premier et deuxième commutateurs (SW1, SW2) tout en ouvrant le troisième commutateur (SW3) en réponse à l'entrée du signal de consigne activant la fonction de calcul de somme et d'amplification des deux signaux de quantité de réception de lumière, et le processeur de signal (16) ferme les premier et troisième commutateurs (SW1, SW3) tout en ouvrant le deuxième commutateur (SW2) en réponse à l'entrée du signal de consigne activant la fonction d'amplification différentielle des deux signaux de quantité de réception de lumière.

3. Circuit intégré de réception de lumière selon la revendication 1, comprenant en outre
une partie de réception de lumière (30) qui comprend un élément de réception de lumière comportant un système de sortie, dans lequel
la ligne de signal provenant de l'une des deux parties d'entrée (10A, 10B) de signal de quantité de réception de lumière fait l'objet d'une ramification en deux trajets,
le processeur de commutation (10) comprend un premier commutateur (SW1) qui est connecté à la partie de réception de lumière (30), un deuxième commutateur (SW12 qui est connecté à la ligne de signal provenant de l'autre partie d'entrée de signal de quantité de réception de lumière dans laquelle la ligne de signal n'a pas fait l'objet d'une ramification, et des troisième et quatrième commutateurs (SW3, SW4) qui sont connectés aux lignes de signal provenant de la partie d'entrée de signal de quantité de réception de lumière dans laquelle la ligne de signal a fait l'objet d'une ramification,
le circuit amplificateur (100) comprend un amplificateur différentiel dans lequel un signal ou des signaux d'addition passant par les premier, deuxième et troisième commutateurs (SW1, SW2, SW3) sert ou servent de première entrée parmi les entrées tandis qu'un signal passant par le quatrième commutateur (SW4) sert d'autre entrée,
le processeur de signal (16) ferme le premier commutateur (SW1) tout en ouvrant les deuxième, troisième et quatrième commutateurs (SW2, SW3, SW4) en réponse à l'entrée du signal de consigne activant la fonction d'amplification de l'unique signal de quantité de réception de lumière, le processeur de signal (16) ferme les deuxième et troisième commutateurs (SW2, SW3) tout en ouvrant les premier et quatrième commutateurs (SW1, SW4) en réponse à l'entrée du signal de consigne activant la fonction de calcul de somme et d'amplification des deux signaux de quantité de réception de lumière, et le processeur de signal (16) ferme les deuxième et quatrième commutateurs (SW2, SW4) tout en ouvrant les premier et troisième commutateur (SW1, SW3) en réponse à l'entrée du signal de consigne activant la fonction d'amplification différentielle des deux signaux de quantité de réception de lumière.

4. Circuit intégré de réception de lumière selon l'une quelconque des revendications 1 à 3, comprenant en outre
une partie de communication (19) qui assure une communication avec un autre circuit intégré (1, 1M, 1S) de réception de lumière du même type, dans lequel
le processeur de signal (16) traite le signal délivré par le circuit amplificateur (100) tout en transmettant une temporisation d'opération de synchronisation de signal à un autre circuit intégré (1, 1M, 1S) de réception de lumière, et en en recevant une de ce dernier, par l'intermédiaire de la partie de communication (19) en réponse à l'entrée de l'un du signal de consigne activant la fonction de calcul de somme et d'amplification des deux signaux de quantité de réception de lumière et du signal de consigne activant la fonction d'amplification différentielle des deux signaux de quantité de réception de lumière.

5. Circuit intégré de réception de lumière selon les revendications 1 à 3, comprenant en outre
une partie de communication (19) qui assure une communication avec un autre circuit intégré (1, 1M, 1S) de réception de lumière du même type, dans lequel
l'un du signal de consigne activant la fonction de calcul de somme et d'amplification des deux signaux de quantité de réception de lumière et du signal de consigne activant la fonction d'amplification différentielle des deux signaux de quantité de réception de lumière amène le processeur de signal (16) du circuit intégré (1, 1M, 1S) de réception de lumière, qui reçoit le signal de consigne, à servir de maître, et l'autre signal de consigne amène le processeur de signal (16) du circuit intégré (1, 1M, 1S) de réception de lumière, qui reçoit le signal de consigne, à servir d'esclave, et
le processeur de signal (16) servant de maître délivre un signal de commande représentant une temporisation, selon laquelle la sortie du circuit amplificateur (100) est prélevée et traitée, au processeur de signal (16) servant d'esclave par le biais de la partie de communication (19), et prélève et traite la sortie du circuit amplificateur (100) du circuit qui lui est propre en réponse à la sortie, et le processeur de signal (16) servant d'esclave prélève et traite la sortie du circuit amplificateur (100) du circuit qui lui est propre en réponse à la réception du signal de commande du processeur de signal (16) servant de maître par l'intermédiaire de la partie de communication (19).

6. Capteur photoélectrique, comprenant :
une partie de projection de lumière (20) qui projette une lumière ; et
un circuit intégré (1, 1M, 1S) de réception de lumière selon la revendication 1 comprenant une partie de réception de lumière (30) qui reçoit la lumière provenant de la partie de projection de lumière (20) ou une lumière réfléchie à partir d'une cible de détection par rapport à la lumière provenant de la partie de projection de lumière (20) et qui délivre un unique signal de quantité de réception de lumière, dans lequel
la partie de réception de lumière (30) est incorporée dans le circuit intégré (1, 1M, 1S) de réception de lumière tout en étant connectée au processeur de commutation (10), et
le signal de consigne activant la fonction d'amplification de l'unique signal de quantité de réception de lumière est délivré à la partie d'entrée (105) de signal de consigne du circuit intégré (1, 1M, 1S) de réception de lumière.

7. Capteur photoélectrique, comprenant :
une partie de projection de lumière (20) qui projette une lumière ;
une partie de réception de lumière (30) comprenant un élément de réception de lumière qui reçoit la lumière réfléchie à partir d'une cible de détection par rapport à la lumière de la partie de projection de lumière (20) et qui délivre deux signaux de quantité de réception de lumière ; et
deux circuits intégrés (1, 1M, 1S) de réception de lumière selon la revendication 1 qui sont connectés à la partie de réception de lumière (30), dans lequel
le signal de consigne activant la fonction de calcul de somme et d'amplification des deux signaux de quantité de réception de lumière est délivré à la partie d'entrée (105) de signal de consigne de l'un des deux circuits intégrés (1M, 1S) de réception de lumière tandis que le signal de consigne activant la fonction d'amplification différentielle des deux signaux de quantité de réception de lumière est délivré à la partie d'entrée (105) de signal de consigne de l'autre circuit intégré (1M, 1S) de réception de lumière.

8. Capteur photoélectrique selon la revendication 7, dans lequel
chacun des deux circuits intégrés (1M, 1S) de réception de lumière comprend en outre une partie de communication (19) qui assure une communication avec l'autre circuit intégré (1M, 1S) de réception de lumière, et
le processeur de signal (16) traite le signal délivré par le circuit amplificateur (100) tout en transmettant un signal de temporisation d'opération de synchronisation des deux circuits intégrés (1M, 1S) de réception de lumière à l'autre circuit intégré (1M, 1S) de réception de lumière, et en en recevant un de ce dernier, par l'intermédiaire de la partie de communication (19).

9. Capteur photoélectrique selon la revendication 8, dans lequel
l'un du signal de consigne activant la fonction de calcul de somme et d'amplification des deux signaux de quantité de réception de lumière et du signal de consigne activant la fonction d'amplification différentielle des deux signaux de quantité de réception de lumière amène le processeur de signal (16) du circuit intégré (1, 1M, 1S) de réception de lumière, qui reçoit le signal de consigne, à servir de maître, et l'autre signal de consigne amène le processeur de signal (16) du circuit intégré (1, 1M, 1S) de réception de lumière, qui reçoit le signal de consigne, à servir d'esclave, et
le processeur de signal (16) servant de maître délivre un signal de commande représentant une temporisation, selon laquelle la sortie du circuit amplificateur (100) est prélevée et traitée, au processeur de signal (16) servant d'esclave par l'intermédiaire de la partie de communication (19), et prélève et traite la sortie provenant du circuit amplificateur (100) du circuit qui lui est propre en réponse à la sortie, et le processeur de signal (16) servant d'esclave prélève et traite la sortie du circuit amplificateur (100) du circuit qui lui est propre en réponse à la réception du signal de commande du processeur de signal (16) servant de maître par l'intermédiaire de la partie de communication (19).
